(19) Europäisches Patentamt
European Patent Office
Office européen des brevets

(11) Veröffentlichungsnummer : **0 433 824 B1**

# (12) EUROPÄISCHE PATENTSCHRIFT

(45) Veröffentlichungstag der Patentschrift : **02.03.94 Patentblatt 94/09**

(51) Int. Cl.$^5$ : **G01R 15/07,** G01R 29/12

(21) Anmeldenummer : **90123660.4**

(22) Anmeldetag : **08.12.90**

(54) **Faseroptischer Sensor.**

(30) Priorität : **22.12.89 CH 4603/89**

(43) Veröffentlichungstag der Anmeldung : **26.06.91 Patentblatt 91/26**

(45) Bekanntmachung des Hinweises auf die Patenterteilung : **02.03.94 Patentblatt 94/09**

(84) Benannte Vertragsstaaten : **CH DE FR GB IT LI SE**

(56) Entgegenhaltungen :
**EP-A- 0 316 619**
**EP-A- 0 316 635**

(56) Entgegenhaltungen :
**US-A- 4 524 322**
**APPLIED OPTICS. vol. 19, no. 17, 01 September 1980, NEW YORK US Seiten 2926 - 2929; JACKSON ET AL.: "Elimination of drift in a single-mode optical fibre interferometer using a piezoelectrically stretched coiled fibre"**

(73) Patentinhaber : **ASEA BROWN BOVERI AG
CH-5401 Baden (CH)**

(72) Erfinder : **Bohnert, Klaus, Dr.
Loonstrasse 9
CH-5443 Niederrohrdorf (CH)**
Erfinder : **Buser, Werner
Birsstrasse 84
CH-4052 Basel (CH)**

EP 0 433 824 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

### Technisches Gebiet

Die Erfindung betrifft einen faseroptischen Sensor zum Messen elektrischer Felder oder Spannungen, bei welchem

a) eine Sensorfaser mit einem gegebenen Längenabschnitt so an mindestens einem piezoelektrischen Sensorelement befestigt ist, dass das zu messende elektrische Feld mittels des inversen piezoelektrischen Effekts zu einer Längenänderung der Sensorfaser führt,

b) Mittel zur interferometrischen Detektion der Längenänderung vorgesehen sind und

c) ein piezoelektrischer Modulator vorgesehen ist, welcher derart angesteuert ist, dass die durch das zu messende elektrische Feld induzierte Längenänderung der Sensorfaser kompensiert wird.

### Stand der Technik

Das Prinzip des SMFI (= Single Mode all Fibre Interferometer) ist von grundlegender Bedeutung für den Einsatz faseroptischer Sensoren in der Praxis. Eine Uebersicht über den Stand der Technik betreffend Sensorelemente und Detektoren bietet die Veröffentlichung "Optical Fiber Sensor Technology", Thomas G. Giallorenzi et al., IEEE J. of Quantum Electronics, Vol. QE-18, No. 4, 4. April 1982.

Einen Spezialfall bilden die aus der Patentveröffentlichung EP-A-0 361 619 bekannten piezoelektrischen Feldsensoren. Diese haben die Eigenschaft, ausschliesslich eine vorgegebene Richtungskomponente eines beliebigen elektrischen Feldes zu detektieren. Wenn ausserdem mehrere solche Sensoren in geeigneter Weise hintereinander geschaltet werden, so kann die Spannung zwischen zwei Punkten im Raum im Sinn eines Linienintegrals über das elektrische Feld gemessen werden. Ein derartiger Spannungssensor ist z.B. aus der Patentveröffentlichung EP-A-0 316 635 bekannt.

Ein faseroptischer Sensor der eingangs genannten Art ist z.B. aus der Veröffentlichung "Elimination of drift in single-mode optical fiber interferometer using a piezoelectrically streched coiled fiber", D. A. Jackson et al., Appl. Optics Vol 19, No. 17, 1. September 1980 bekannt. In diesem Artikel wird aufgezeigt, wie ein SMFI mit einer piezoelektrisch gestreckten Faserspule im optimalen Arbeitspunkt gehalten werden kann. Die faseroptische Anordnung entspricht dabei einem Mach-Zehnder-Interferometer. Als Detektionsschema wird vorzugsweise die Homodyne-Detektion eingesetzt. Während ein Arm des Interferometers dem zu messenden Signal ausgesetzt wird, sorgt ein Kompensator im zweiten Arm dafür, dass der Phasenunterschied zwischen den beiden Armen auf Null abgeglichen wird. Im Hinblick auf eine grosse Dynamik des Systems wird als Kompensator eine zylinderförmige piezoelektrische Keramik verwendet, auf welche die Faser aufgewickelt ist.

Ein Problem grundlegender Art stellt beim Stand der Technik die Temperaturabhängigkeit des Sensorsignals dar. Im üblicherweise geforderten Arbeitsbereich von -40 bis +70 °C hat sie Fehler im Bereich von typischerweise einigen Prozenten zur Folge. Für piezoelektrische Sensoren basierend auf Quarz beispielswese ist der Fehler die kombinierte Temperaturabhängigkeit von Piezokoeffizienten, Dielektrizitätskonstanten und Faserinterferometer, unter der Voraussetzung, dass das Kompensatormaterial auf konstanter Temperatur gehalten wird.

### Darstellung der Erfindung

Aufgabe der Erfindung ist es, einen faseroptischen Sensor der eingangs genannten Art anzugeben, der die beim Stand der Technik vorhandenen Nachteile bezüglich der Temperaturabhängigkeit vermeidet.

Erfindungsgemäss besteht die Lösung darin, dass

- der piezoelektrische Modulator mindestens ein piezoelektrisches Modulatorelement umfasst, welches bezüglich Material, geometrischer Form und Kristallorientierung identisch mit dem mindestens einen Sensorelement ist,
- Modulatorelement und Sensorelement sich im wesentlichen auf gleicher Temperatur befinden und
- zusätzlich separate Mittel zur Arbeitspunktkontrolle vorgesehen sind.

Der Kern der Erfindung liegt darin, dass die Anteile S(t) (Signal) und $\phi(t)$ (willkürlicher Phasenterm) der totalen optischen Phasenschiebung $\Phi(t) = S(t) + \phi(t)$, welche sich aus der Längenänderung der Faser ergibt, separat kompensiert werden. Die Kompensation des gesuchten Signals S(t) erfolgt mit einem Modulator, der bezüglich Material und Geometrie identisch mit dem detektierenden Sensor ist. Wenn Sensor und Modulator auf annähernd gleicher Temperatur gehalten werden, ist somit das resultierende Ausgangssignal (= Steuersignal des Modulators) weitgehend frei von Temperatureinflüssen. Denn sowohl Sensorelement als auch Modulatorelement haben in diesem Fall identische Eigenschaften (Piezokoeffizienten, Dielektrizitätskonstanten).

Das im Sensorelement wirkende, zu messende elektrische Feld kann somit nur durch ein Feld gleicher oder - abhängig vom Verhältnis der Windungszahlen - proportionaler Stärke im Modulator abgeglichen werden.

Der Arbeitspunkt des erfindungsgemässen faseroptischen Sensors wird auf einem Wert $\Phi(t) = (2n + 1) \pi/2$ festgehalten.

Die zusätzlichen Mittel zur Arbeitspunktkontrolle können somit auf die im allgemeinen grosse und im Vergleich zum Signal S(t) langsame thermische Drift $\phi(t)$ hin dimensioniert werden und zwar unabhängig von den Sensormaterialien mit ihren oft ziemlich kleinen Piezokoeffizienten.

Die Erfindung schafft somit auch ein Verfahren zum Messen eines elektrischen Feldes oder einer elektrischen Spannung, bei welchem

a) Licht, das in einer Sensorfaser geführt wird, durch eine mittels eines piezoelektrischen Sensorelements induzierte Längenänderung der Sensorfaser eine Phasenverschiebung erleidet,

b) die Phasenverschiebung interferometrisch detektiert wird und

c) mit einem auf die Sensorfaser einwirkenden piezoelektrischen Modulator gemäss einem Steuersignal auf Null abgeglichen wird, wobei aus dem Steuersignal die Stärke des Feldes resp. der Spannung ermittelt wird,

welches sich dadurch auszeichnet, dass

d) im Modulatur Modulatorelemente verwendet werden, die bezüglich Material geometrischer Form und Kristallorientierung identisch mit dem piezoelektrischen Sensorelement sind,

e) Sensor- und Modulatorelemente auf gleicher Temperatur gehalten werden und

f) zur Arbeitspunktkontrolle ein separater Arbeitspunktregler mit grossem Phasenhub verwendet wird, so dass ein Dynamikbereich von mindestens $+/-2\pi$ erreicht wird,

Im folgenden werden einige bevorzugte Ausführungsformen der Erfindung angegeben.

Für die Erfindung eignen sich verschiedene Detektionskonzepte. In jedem Fall ist es aber vorteilhaft, wenn Sensorelement und Modulator auf die selbe Glasfaser, nämlich die Sensorfaser einwirken. Auf diese Weise können die Fluktuationen des detektierten Signals kleiner gehalten werden als wenn Sensorelement und Modulator auf verschiedene Glasfasern einwirken.

Neben einem Mach-Zehnder-Interferometer wird im besonderen auch ein Zweimoden-Interferometer, kurz TMFI (= **T**wo **M**ode **F**iber **I**nterferometer), bevorzugt, da bei einer solchen Anordnung einerseits keine teuren Faserkoppler benötigt werden und andererseits die Zahl der Splices klein gehalten werden kann. Ausserdem wird keine Referenzfaser benötigt.

Als Sensorelementmaterial eignet sich Quarz wegen seiner Langzeitstabilität und seiner guten Verfügbarkeit ausgezeichnet. Besonders bevorzugt sind richtungsempfindliche Sensoren, wie sie z.B. aus der bereits zitierten Veröffentlichung EP-A-0 316 619 bekannt sind. Sie haben den Vorteil, dass ausschliesslich eine vorbestimmte Richtungskomponente des elektrischen Feldes zu einer Längenänderung der Faser führen kann. Feldkomponenten, die senkrecht zur vorgegebenen Richtungskomponente stehen, können nicht zu einem Sensorsignal führen. Somit kann garantiert werden, dass im Sensor keine anderen Richtungskomponenten des zu messenden Feldes einen Einfluss auf das Signal haben als im Modulator.

Um im Modulator bei gegebener maximal möglicher Steuerspannung auch grössere Messignale kompensieren zu können, werden im Modulator mit Vorteil mehrere gleiche Modulatorelemente aufeinandergestapelt, deren Elektroden elektrisch parallel angesteuert werden. Zusätzlich kann die Sensorfaser an jedem Modulatorelement mit einem grösseren Längenabschnitt befestigt sein als am entsprechenden Sensorelement. Das resultierende hohe Uebersetzungsverhältnis ist insbesondere bei Hochspannungsanwendungen von Vorteil.

Die Mittel zur Arbeitspunktkontrolle lassen sich auf verschiedene Arten verwirklichen.

Eine erste bevorzugte Möglichkeit stellt ein piezokeramischer (PZT) Hohlzylinder dar, um den die Sensorfaser mit mehreren Windungen gewickelt ist. Der Vorteil dieser piezoelektrischen Lösung liegt darin, dass keine beweglichen Teile benötigt werden (wie dies bei den mechanischen Faserstreckern der Fall ist).

Eine zweite Möglichkeit stellt ein mechanischer Faserstrecker dar. Bei diesem ist die Sensorfaser an zwei beabstandeten Punkten fixiert, so dass der dazwischen liegende Abschnitt in Abhängigkeit vom Kompensationssignal gestreckt werden kann. Die Streckung wird vorzugsweise mit einem Elektromagneten, einem Bimetallelement oder einem Schrittmotor in Verbindung mit einem Schneckengetriebe herbeigeführt. Diese mechanischen Faserstrecker haben den Vorteil, dass sie nur wenig Faserlänge (typischerweise weniger als 0.3 m) beanspruchen.

Eine dritte Möglichkeit besteht schliesslich darin, dass die Wellenlänge des zur Detektion verwendeten Laserlichts variiert wird. Hier kann die Arbeitspunktkontrolle ohne zusätzliche Bauteile durchgeführt werden. Insbesondere werden keine beweglichen Teile benötigt. Schliesslich ist auch der Faserbedarf geringer.

Die Mittel zur interferometrischen Detektion werden vorzugsweise nach dem Prinzip der Homodyne-Detektion ausgeführt. Ein erster PI-Regler mit einer oberen Grenzfrequenz oberhalb einer Frequenz (z.B. 5 kHz) des zu messenden elektrischen Feldes (technisches Wechselfeld) steuert den Modulator an. Ein zweiter

PI-Regler mit einer Grenzfrequenz unterhalb der genannten Frequenz (z.B. 0 - 10 Hz) steuert den Arbeitspunkt. Gemäss einer besonders bevorzugten Ausführungsform ist zudem eine Reset-Schaltung vorgesehen, die den zweiten PI-Regler zurücksetzt (Rücksprung um $2\pi$ oder ein vorgegebenes Vielfaches davon), falls dessen Aussteuerbereich überschritten wird.

Die Erfindung eignet sich auch für die Messung von elektrischen Spannungen, wenn das Sensorelement in der Art eines Feldintegrators ausgeführt ist.

Vorzugsweise wird die Erfindung zum Messen von Feldern resp. Spannungen in gasisolierten Schaltanlagen verwendet. In diesem Fall kann die annähernd gleiche Temperatur dadurch gewährleistet werden, dass die Sensorelemente innen und die Modulatorelemente aussen am metallischen Aussenrohr befestigt sind.

Weitere bevorzugte Ausführungsformen ergeben sich aus der nachfolgenden Beschreibung.

## Kurze Beschreibung der Zeichnungen

Nachfolgend soll die Erfindung anhand von Ausführungsbeispielen und im Zusammenhang mit den Zeichnungen näher erläutert werden. Es zeigen:

Fig. 1 eine schematische Darstellung eines faseroptischen Sensors zum Messen elektrischer Felder;
Fig. 2 einen Modulator mit mehreren Modulatorelementen;
Fig. 3 einen Faserstrecker, bei welchem die Längenänderung der Sensorfaser mechanisch durch einen Elektromagneten bewirkt wird;
Fig. 4 einen Faserstrecker, bei welchem die Längenänderung der Sensorfaser mechanisch durch einen Bimetallstrecker bewirkt wird;
Fig. 5 einen Faserstrecker, bei welchem die Längenänderung der Sensorfaser mechanisch durch einen Schrittmotor in Verbindung mit einem Schneckengetriebe bewirkt wird; und
Fig. 6 einen faseroptischen Sensor zum Messen elektrischer Spannungen.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

## Wege zur Ausführung der Erfindung

Fig. 1 zeigt ein erstes Ausführungsbeispiel der Erfindung. Mit dem schematisch dargestellten faseroptischen Sensor wird ein elektrisches Feld E (z.B. ein Wechselfeld einer gegebenen Frequenz) gemessen.

Ein Laser 1a koppelt kohärentes Licht einer fest vorgegebenen Frequenz (resp. Wellenlänge) in eine Sensorfaser 2 ein. Diese ist gemäss einer besonders vorteilhaften Ausführungsform eine Zwei-Moden-Faser, kurz TMF (=Two Mode Fiber) genannt. In ihr wird das Licht des Lasers 1a in zwei Moden geführt, die bei einer Dehnung der Faser eine unterschiedliche Phasenschiebung erfahren. Die Dehnung der Sensorfaser 2 wird mit mindestens einem piezoelektrischen Sensorelement 3 bewirkt. Die Sensorfaser 2 ist zu diesem Zweck mit einem gegebenen Längenabschnitt vorzugsweise so am Sensorelement 3 befestigt, dass ausschliesslich eine vorgegebene Richtungskomponente des elektrischen Feldes mittels des inversen piezoelektrischen Effekts zu einer Längenänderung der Sensorfaser 2 führen kann.

Eine grosse Zahl von solchen richtungsempfindlichen Sensorelementen ist z.B. in der bereits zitierten Veröffentlichung EP-A-0 316 619 beschrieben. Besonders bevorzugt wird ein rundes, scheibenförmiges Sensorelement aus einkristallinem Quarz, bei welchem eine zweizählige kristallographische Drehachse (x-Richtung) senkrecht zur Hauptfläche des Sensorelements orientiert ist. Die Sensorfaser 2 ist mehrere Male um die Scheibe gewickelt. Damit ist das Sensorelement nur für Feldkomponenten empfindlich, die parallel zur Scheibennormalen stehen.

Die durch das elektrische Feld E induzierte differentielle Phasenschiebung der beiden Moden wird gemäss der Erfindung kompensiert, wobei ein für die Kompensation benötigtes Signal als Mass für die zu messende Feldstärke verwendet werden kann. Die Kompensation erfolgt in zwei separaten Schritten. Im vorliegenden Beispiel wird im ersten Schritt der Arbeitspunkt eingestellt und im zweiten Schritt das durch das elektrische Feld E induzierte Signal kompensiert.

Die Mittel für die Arbeitspunktkontrolle umfassen vorzugsweise einen piezokeramischen Arbeitspunktregler 4, wie er bisher für allgemeine Modulationszwecke verwendet worden und z.B. aus dem bereits erwähnten Artikel von D. A. Jackson et al. bekannt ist. Ein Arbeitspunktregler 4 wird gemäss der Erfindung durch einen grossen, relativ dünnwandigen Hohlzylinder aus PZT (Piezokeramik) gebildet, um den die Sensorfaser mehrmals herumgewickelt ist. Innen und aussen ist der Hohlzylinder je mit einer schichtartigen Elektrode versehen. Wenn an diese eine Spannung angelegt wird, ändert sich der Umfang des Hohlzylinders und damit die Länge der Sensorfaser 2. Damit der Arbeitspunktregler 4 bei gegebener Faserwindungszahl mit möglichst kleinen

Spannungen (vorzugsweise < 1kV) angesteuert werden kann, sind die Wanddicke klein (z.B. 1-2 mm) und der Durchmesser gross (einige cm, z.B. 5 cm) zu halten.

Nach dem Arbeitspunktregler 4 folgt ein Modulator 5. Dieser weist mindestens ein Modulatorelement 12a auf, das bezüglich Material, Geometrie und kristallografischer Orientierung identisch mit dem Sensorelement 3 ist. Aus fertigungstechnischer Sicht kann es von Vorteil sein, wenn auch die Körperabmessungen gleich sind.

Gemäss dem vorliegenden Ausführungsbeispiel ist somit das Modulatorelement 12a ebenfalls scheibenförmig und aus einkristallinem Quarz der genannten kristallographischen Orientierung. Im Gegensatz zum Sensorelement 3 ist aber das Modulatorelement 12a an seinen beiden Hauptflächen je mit einer Elektrode beschichtet. Ausserdem ist die Sensorfaser 2 vorzugsweise mit einer grösseren Anzahl Windungen befestigt als am Sensorelement 3, so dass eine Art Uebersetzung resultiert. Dies bedeutet, dass beim Modulatorelement eine geringere Feldstärke benötigt wird, um die selbe Phasenschiebung wie im Sensorelement zu bewirken.

Ein wichtiger Punkt bei der Erfindung sind die Vorkehrungen, die gewährleisten, dass sich Sensor- und Modulatorelemente auf annähernd gleicher Temperatur befinden. Auf diese Weise wird sichergestellt, dass die Materialeigenschaften (z.B. Piezokoeffizienten, Dielektrizitätskonstanten) des Modulatorelements sich im wesentlichen nicht unterscheiden von denjenigen des entsprechenden Sensorelements. Das Steuersignal des Modulatorelements ist somit weitgehend frei von Temperaturfehlern und kann direkt zur Ermittlung der elektrischen Feldstärke verwendet werden. Die Auswertung übernimmt eine Auswerteschaltung 27a.

Wie gross der Temperaturunterschied zwischen Modulator- und Sensorelement sein darf, hängt von der geforderten Messgenauigkeit ab. Typischerweise wird von faseroptischen Sensoren gemäss der Erfindung gefordert, dass sie in einem Temperaturbereich von -40°C bis +70°C betrieben werden können. In diesem Bereich können temperaturbedingte Fehler von mehreren Prozenten auftreten. Um diese Fehler weitgehend zu eliminieren, sollte die Temperaturdifferenz nicht mehr als einige wenige Grad Celsius betragen.

In der Praxis ist dies hinreichend gut gewährleistet, wenn z.B. Sensor- und Modulatorelement beide den gleichen Umgebungsbedingungen ausgesetzt sind. Im Spezialfall gasisolierter Schaltanlagen beispielsweise lässt sich dies so realisieren, dass das Sensorelement an der Innenseite und das Modulatorelement an der Aussenseite des abschirmenden, metallischen Aussenrohres angebracht ist.

Am Ende der Sensorfaser 2 sind Detektionsmittel 6 angeordnet. Sie umfassen typischerweise zwei Photodetektoren und einen Differenzbilder. Er gibt ein Signal aus, das der kohärenten optischen Ueberlagerung der beiden in der Sensorfaser 2 geführten Eigenmoden entspricht. Das Signal der Detektionsmittel 6 wird verwendet, um einerseits den Modulator 5 und andererseits den Arbeitspunktregler 4 anzusteuern. Die Ansteuerung zielt darauf ab, dass das Ausgangssingal des Differenzbilders stets auf Null gehalten wird. Damit ist die Detektion stets auf den Punkt höchster Empfindlichkeit abgestimmt. Im folgenden wird nun die erfindungsgemässe Ansteuerung im einzelnen beschrieben.

Gemäss einer bevorzugten Ausführungsform erfolgt die Signalerfassung mit einem an sich bekannten Homodyne-Detektionsverfahren. Zwei Photodetektoren messen die optischen Interferenzsignale (die sich aus der Ueberlagerung des Grundmodes mit einem Mode erster Ordnung ergeben) und erzeugen zwei um 180° phasenverschobene elektrische Spannungen

$$V_1 = V_0(1 + \alpha \cos\Phi(t))$$
$$V_2 = V_0(1 - \alpha \cos\Phi(t))$$
$$\Phi(t) = S(t) + \phi(t)$$

Die totale Phasenverschiebung $\Phi(t)$ zwischen den beiden interferierenden Wellen resp. Moden setzt sich zusammen aus einem durch das zu messende elektrische Feld $\underline{E}$ hervorgerufenen Anteil S(t) und einem willkürlichen Phasenterm $\phi(t)$. Letzterer ändert sich (falls keine Arbeitspunktkontrolle durchgeführt wird) infolge von temperaturbedingten Fluktuationen der Faserlänge langsam mit der Zeit. Die Grösse $V_0$ ist proportional zur optischen Eingangsleistung und $\alpha$ ist ein Mass für den Interferenzkontrast.

Aus den beiden Spannungen $V_1$ und $V_2$ wird ein Differenzsignal

$$V_3 = V_2 - V_1 = 2\,V_0 \cos\Phi(t)$$

gebildet und am Ausgang der Detektionsmittel 6 an einen ersten PI-Regler 7a abgegeben. Der erste Pi-Regler 7a erzeugt ein erstes Steuersignal, das über einen Verstärker 8 als Steuerspannung dem Modulator 5 zugeführt wird. Das Steuersignal ist proportional zum Signal S(t) und sorgt dafür, dass die durch das zu messende elektrische Feld hervorgerufene Phasenverschiebung S(t) ständig auf Null abgeglichen wird. Die durch das Sensorelement induzierte Phasenverschiebung wird folglich durch den Modulator über eine entsprechende (entgegengesetzte) Längenänderung der Sensorfaser gerade ausgeglichen.

Die Auswerteschaltung 27a beschränkt sich also darauf, das Differenzsignal $V_3$ mit einem bestimmten Proportionalitätsfaktor zu multiplizieren, so dass der gewünschte Wert für die Stärke des Feldes $\underline{E}$ resultiert.

Ein besonderes Kennzeichen der Erfindung ist die Trennung der Kompensation von Signal und Temperaturdrift. Zur Kompensation der Temperaturdrift sind ein zweiter PI-Regler 9a und ein zweiter Verstärker 10 vorgesehen. Der zweite PI-Regler 9a ist in Serie zum ersten PI-Regler 7a geschaltet. Er hat eine obere Grenzfrequenz von 5 - 10 Hz, so dass das dem zweiten Verstärker 10 zugeführte zweite Steuersignal (resp. die vom Verstärker 10 an den piezokeramischen Arbeitspunktregler 4 angelegte Spannung) dafür sorgt, dass alle Fluktuationen der Phasenverschiebung im Frequenzbereich unterhalb der oberen Grenzfrequenz durch den Arbeitspunktregler 4 abgeglichen werden.

Die Grenzfrequenz des ersten PI-Reglers 7a zur Ansteuerung des Modulators liegt oberhalb der Frequenz des Messignals (das i.a. eine technische Wechselstromfrequenz ist), z.B. bei 5 kHz. Dieser PI-Regler kompensiert alle Phasenverschiebungen im Frequenzband zwischen seiner eigenen Grenzfrequenz und der Grenzfrequenz des zweiten PI-Reglers 9a.

Bei starken Temperaturschwankungen kann der thermisch induzierte Anteil $\phi(t)$ der optischen Phasenverschiebung (auch bei dem im Vergleich zum Mach-Zehnder-Interferometer weniger empfindlichen TMFI) viele Vielfache von $2\pi$ betragen und damit den Dynamikbereich des Arbeitspunktreglers 4 weit übertreffen. Um die damit verbundenen Probleme zu vermeiden, umfassen die Mittel zur Arbeitspunktkontrolle vorzugsweise eine Reset-Schaltung 11. Diese sorgt dafür, dass der zweite PI-Regler 9a einen vorbestimmten Wert zurückgesetzt wird, wenn der Pi-Regler 9a einen vorbestimmten, maximalen, positiven oder negativen Grenzwert erreicht. Dieses Entladen des PI-Reglers 9a entspricht einem Verschieben des Arbeitspunktes des Interferometers um ein Vielfaches von $2\pi$. Daraus folgt, dass der Dynamikbereich des Arbeitspunktreglers 4 mindestens einer Verschiebung des genannten Arbeitspunktes um +/- 2 $\pi$ entsprechen muss.

Eine in diesem Sinn geeignete Ausführungsform des Arbeitspunktreglers wird z.B. durch einen piezokeramischen Hohlzylinder mit 50 mm Durchmesser und 2 mm Wandstärke gebildet, der in radialer Richtung gepolt ist und dabei folgende Piezokoeffizienten aufweist:

$$d_{33} = 565\ 10^{-12}\ m/V$$
$$d_{31} = -230\ 10^{-12}\ m/V$$
$$d_{15} = 730\ 10^{-12}\ m/V$$

(VIBRIT 668 von der Firma SIEMENS)

Bei einem maximalen Spannungshub von +/-1 kV (Feld parallel zur Polarisationsrichtung des Hohlzylinders angelegt) kann eine Phasenverschiebung von etwa +/-$20\pi$ kompensiert werden, wenn auf den Hohlzylinder 5 m Sensorfaser aufgewickelt sind.

Das anhand der Fig. 1 beschriebene Ausführungsbeispiel lässt eine grosse Zahl von erfindungsgemässen Abwandlungen zu. Diese sollen im folgenden erläutert werden.

Fig. 2 zeigt einen Modulator mit mehreren Modulatorelementen 12a ,..., 12e. Gemäss einer vorteilhaften Ausführungsform sind die Modulatorelemente 12a ,..., 12e scheibenförmig. Bezüglich Material, geometrischer Form und Orientierung der Kristallachsen sind sie alle identisch mit dem Sensorelement. Sie sind zu einem Zylinder aufgestapelt. Zwischen den mit den Hauptflächen aufeinander liegenden Modulatorelementen 12a und 12b, 12b und 12c, 12c und 12d, 12d und 12e ist jeweils eine Elektrode 13b, 13c, 13d, 13e angeordnet. Anfang und Ende des Zylinders sind ausserdem ebenfalls mit einer Elektrode 13a und 13f versehen. Somit befindet sich jedes Modulatorelement zwischen zwei Elektroden.

Die Sensorfaser 2 wird auf den Zylinder so aufgewickelt, dass auf jedes Element gleichviele Wicklungen fallen.

Die vorzugsweise richtungsempfindlich ausgebildeten Modulatorelemente 12a, ..., 12e sind kristallographisch so orientiert, dass die Beiträge der einzelnen Elemente phasenrichtig addiert werden. Im vorliegenden Fall sind die zweizähligen Kristallachsen benachbarter Modulatorelemente (angedeutet durch die Pfeile) jeweils in entgegengesetzt gleicher Richtung orientiert.

Die Elektroden sind so am Verstärker angeschlossen, dass über jedem Modulatorelement die volle Steuerspannung anliegt. Die in axialer Richtung des Stapels erste, dritte und fünfte Elektrode 13a, 13c und 13e liegen auf gleichem Potential, d.h. sie sind parallel geschaltet. Analoges gilt für die zweite, vierte und sechste Elektrode 13b, 13d, und 13f.

Der Vorteil des mehrschichtigen resp. gestapelten Modulators liegt im Uebersetzungsverhältnis, das sich auf diese Weise zwischen der vom Sensorelement detektierten Feldstärke und der vom Verstärker zu erbringenden Spannung (resp. in einem einzigen Modulatorelement herrschenden Feldstärke) einstellt.

Das Signal S(t) beträgt beim SMFI typischerweise 0.1 rad 1rms. Um dieses Signal zu kompensieren sind je nach Fasertyp ca. 3 bis 5 Quarzscheiben erforderlich, falls a) die Modulationsspannung einen maximalen Hub von +/-3 kV hat, b) der Durchmesser und die Dicke der Scheiben 25 mm resp. 5 mm betragen und c) 15 Windungen Sensorfaser pro Scheibe vorgesehen sind.

Der Modulator gemäss Fig. 2 im allgemeinen und die genannten Parameterwerte im besonderen stellen bevorzugte Ausführungsformen der Erfindung dar.

Die im folgenden erläuterten Variationen der Erfindung beziehen sich auf die Mittel zur Arbeitspunktkontrolle.

Die Figuren 3 bis 5 zeigen im wesentlichen mechanische Faserstrecker, die alternativ zum

piezokeramischen Hohlzylinder verwendet werden können.

Fig. 3 zeigt schematisch einen Faserstrecker, bei dem eine Längenänderung der Sensorfaser 2 durch einen Elektromagneten bewirkt wird. Auf einem Träger 14a ist eine Halterung 15a vorgesehen, mit der die Sensorfaser 2 an einem Punkt A fixiert werden kann. In einem gegebenen Abstand von der Halterung 15a befinden sich Mittel zum Dehnen der Sensorfaser 2.

Im Ausführungsbeispiel gemäss Fig. 3 handelt es sich bei diesen Mitteln um zwei Blattfedern 16a, 16b und einen dazwischen angeordneten Elektromagneten 17 mit einer Achse 18. An dieser ist die Sensorfaser 2 in einem Punkt B mit geeigneten Mitteln fixiert. Die Achse 18, die von den beiden Blattfedern 16a, 16b in axialer Richtung federnd gehalten wird, spannt einen gegebenen Längenabschnitt der Sensorfaser 2 vor, nämlich den Abschnitt zwischen den beiden Punkten A und B.

Wenn nun der Elektromagnet 17 vom tieffrequenten Kompensationssignal (des zweiten PI-Reglers) angesteuert wird, dann wird die Sensorfaser, d.h. der Abschnitt zwischen den beiden Punkten A und B, einer entsprechenden Dehnung unterworfen. Die auf diese Weise induzierte Phasenschiebung des geführten Laserlichts kompensiert die Drift des erwähnten willkürlichen Phasenterms $\phi(t)$.

Fig. 4 zeigt eine weitere Möglichkeit zur Erzeugung der Faserstreckung. Hier wird die Dehnung durch ein Bimetallelement bewirkt. Analog zu Fig. 3 wird die Sensorfaser 2 in einem Punkt A von einer Halterung 15b fixiert. In einem gegebenen Abstand von dieser Halterung 15b ist auf einem Träger 14b ein Bimetallstreifen 19 in einer Halterung 22a, 22b angeordnet. Er weist Mittel zum Fixieren der Sensorfaser 2 in einem Punkt B auf. Der Bimetallstreifen 19 steht in thermischem Kontakt mit einem Heizelement 20, welches von einer Stromquelle 21 angetrieben wird.

Wenn der Stromquelle 21 das Ausgangssignal des zweiten PI-Reglers 9a (Fig. 1) zugeführt wird, erleidet der Abschnitt zwischen den Punkten A und B der Sensorfaser 2 aufgrund der thermisch induzierten Biegung des Bimetallstreifens 19 die gewünschte driftkompensierende Längenänderung.

Im Ausführungsbeispiel der Fig. 4 kann anstelle des Heizelements z.B. auch ein Peltierelement Anwendung finden.

Fig. 5 zeigt eine dritte, ebenfalls bevorzugte Variante des Faserstreckers. Aehnlich wie in den vorhergehenden Beispielen ist auf einem Träger 14c eine Halterung 15c zum Fixieren der Sensorfaser 2 im Punkt A vorgesehen. Die Streckung der Sensorfaser 2 wird nun aber durch einen Schrittmotor 23 bewirkt. Dieser treibt ein Schneckengewinde 24 an, an dem wiederum die Sensorfaser 2 mit dem Punkt B befestigt ist. Der Schrittmotor 23 wird von einer Schrittmotorsteuerung geführt, die wiederum vom zweiten PI-Regler angesteuert ist. Auf diese Weise wird direkt die gewünschte driftkompensierende Längenänderung der Sensorfaser 2 erzeugt.

Die soeben beschriebenen mechanischen Faserstrecker haben den Vorteil, dass sie mit einer relativ geringen Faserlänge auskommen. Der massgebliche Abschnitt zwischen den Punkten A und B hat typischerweise eine Länge von 30 bis 50 cm. Auf jeden Fall ist der Faserbedarf geringer als 1 m.

Es gibt noch weitere Möglichkeiten den temperaturabhängigen, willkürlichen Phasenterm $\phi(t)$ zu kompensieren. Gemäss einer besonders bevorzugten Ausführungsform wird zu diesem Zweck die Wellenlänge des Laserlichts variiert. Dies soll nachfolgend im Zusammenhang mit einem faseroptischen Sensor zum Messen einer Spannung beschrieben werden.

Fig. 6 zeigt schematisch einen derartigen faseroptischen Sensor zum Messen einer elektrischen Spannung. Ein Laser 1b koppelt Licht in eine Sensorfaser 2, z.B. eine TMF ein. Ein piezoelektrischer Spannungssensor 25 detektiert die Potentialdifferenz zwischen zwei Raumpunkten C und D. Der Spannungssensor 25 ist als solcher aus der bereits erwähnten Druckschrift EP-A-0 316 635 bekannt. Er besteht aus einer bestimmten Anzahl von richtungsempfindlichen, piezoelektrischen Sensorelementen, die durch geeignete Abstandselemente getrennt hintereinander zwischen den Raumpunkten C und D angeordnet sind.

Wenn gemäss einer bevorzugten Ausführungsform die richtungsempfindlichen Sensorelemente scheibenförmig sind, dann hat der Spannungssensor 25 insgesamt die Form eines langen Zylinders. Die Sensorfaser 2 ist um diesen Zylinder gewickelt, wobei darauf geachtet worden ist, dass die Abstandsscheiben selbst keine feldinduzierte Längenänderung der Sensorfaser 2 bewirken können.

Besonders vorteilhaft ist es, wenn alle Sensorelemente des Spannungssensors und die Abstandsscheiben untereinander identisch sind. Der Spannungssensor bildet dann ein diskretisiertes Linienintegral, wobei alle Summanden mit gleichen Gewichten zum Gesamtsignal beitragen.

In bezug auf den Spannungssensor ist noch folgendes zu beachten. Der Spannungssensor stellt ein mehrschichtiges Dielektrikum dar. Das auf die einzelnen Sensorelemente (z.B. Quarzscheiben) wirkende Feld wird unter anderem durch die Dielektrizitätskonstanten der Abstandsscheiben bestimmt. Die Abstandsscheiben sollten daher aus einem Material sein, das keine oder nur eine geringe Temperaturabhängigkeit der Dielektrizitätskonstanten aufweist. Anderenfalls wird das auf die Sensorelemente des Spannungssensors einwirkende elektrische Feld temperaturabhängig. Diese Temperaturabhängigkeit wird aber mit dem beschriebenen Verfahren nicht kompensiert. Ein solcher Temperatureffekt könnte nur dadurch beseitigt werden, dass entsprechende Abstandsscheiben auch im Modulator integriert würden. Dies würde aber zu einer Vergrösserung der Elektrodenabstände führen, was (wegen der geringeren Feldstärke im Kristallmaterial) eine Verringerung der maximal erreichbaren kompensierenden Phasenverschiebung zur Folge hätte.

Aus den genannten Gründen werden als Materialien für die Abstandsscheiben Teflon, Polytetrafluorethylen, Tetrafluorethylenhexafluorpropylen, Quarzglas oder Polyethylen besonders bevorzugt.

Vom Spannungssensor 25 führt die Sensorfaser 2 zu einem Modulator 26. Dieser hat im wesentlichen den in Fig. 2 gezeigten Aufbau. Er besteht der Einfachheit halber aus möglichst wenig Modulatorelementen. Die genaue Anzahl der Modulatorelemente ergibt sich aus der Grösse des zu kompensierenden Signals und der maximalen Steuerspannung im Modulator. Die Modulatorelemente sind bezüglich Material geometrischer Form und Kristallorientierung identisch mit den Sensorelementen. Durch geeignete Wahl der Anzahl Wicklungen pro Modulatorelement (und der gesamten Zahl Elemente) kann analog zum ersten Ausführungsbeispiel ein gewünschtes Uebersetzungsverhältnis zwischen der zu messenden Potentialdifferenz und der Steuerspannung des Modulators erzielt werden.

Vom Modulator 26 führt die Sensorfaser 2 zu den Detektionsmitteln 6. Diese können identisch mit dem anhand der Fig. 1 beschriebenen sein. Ein von den Detektionsmitteln 6 geliefertes Differenzsignal wird einem ersten PI-Regler 7b zugeführt, der ein Steuersignel an einen Verstärker 8 abgibt. Der Verstärker 8 seinerseits treibt den Modulator 26 an.

Das Steuersignal des ersten PI-Reglers 7b wird ausserdem einem zweiten PI-Regler 9b und einer Auswerteschaltung 27b (die typischerweise einen Verstärker zur Skalierung des Steuersignals umfassen) zugeführt. Letztere ermittelt die dem Steuersignal entsprechende Spannung zwischen den Raumpunkten C und D.

Für die Detektionsmittel 6 und die beiden PI-Regler 7b, 9b gilt im Prinzip dasselbe, was im Zusammenhang mit dem ersten Ausführungsbeispiel (Fig. 1) gesagt worden ist. In Abweichung jedoch zu Fig. 1 steuert der zweite PI-Regler 9b nicht einen Faserstrecker, sondern die Wellenlänge des Lasers 1b. Diese kann bei einem Monomode-Halbleiterlaser entweder über den Betriebsstrom oder die Temperatur des Lasers 1b eingestellt werden.

Bei einer monomode Laserdiode ergibt eine Aenderung des Betriebsstroms um 1 mA je nach Diodentyp eine Wellenlängenverschiebung zwischen 0.01 nm und 0.2 nm. Aehnliche Werte ergeben sich bei einer Temperaturänderung von 1°C. Um ein Springen zwischen benachbarten Moden zu vermeiden, ist eine Strom- resp. Temperaturänderung der Diode auf ca. 2 mA resp. 2°C zu beschränken.

Für die differentielle Phasenverschiebung $\delta\phi$ gilt:

$$\delta\phi = 2\pi l \frac{d}{d\lambda}\left[\frac{1}{L_B}\right]\delta\lambda$$

wobei
l = Länge der Sensorfaser
$\delta\lambda$ = Wellenlängenverschiebung
$L_B$ = Beat-Länge
(Die Beat-Länge ist die Strecke, auf der sich zwischen den beiden Moden der Sensorfaser eine Phasenverschiebung von $2\pi$ akkumuliert.)

Der Ausdruck

$$\frac{d}{d\lambda}\left[\frac{1}{L_B}\right]$$

ist stark von der Wellenlänge abhängig. Es gibt immer eine Wellenlänge (welche von der Faserkerngrösse und der Brechungsindexdifferenz $\delta n$ zwischen Faserkern und Fasermantel abhängt), bei der der oben genannte Ausdruck gleich Null ist. Um eine genügend grosse Phasenverschiebung $\delta\phi$ pro Wellenlängenänderung $\delta\lambda$ zu erhalten, müssen die Wellenlänge des Lasers und die Faserparameter folglich aneinander angepasst werden.

Für eine 10 m lange Sensorfaser mit $\delta n = 0.033$, Kernradius $r = 1.2$ µm umd eine Wellenlänge $\lambda = 830$ nm ist $\delta\phi = 36$ rad für $\delta = 0.1$ nm. Damit lässt sich problemlos eine erfindungsgemässe Arbeitspunktkontrolle durchführen, wie sie im übrigen anhand der Fig. 1 erläutert worden ist.

Es versteht sich, dass die Arbeitspunktkontrolle durch Aendern der Wellenlänge nicht nur für das soeben beschriebene Ausführungsbeispiel (Fig. 6), sondern auch für alle anderen erfindungsgemässen Formen des

faseroptischen Sensors geeignet ist.

Anstelle des TMFI kann z.B. auch ein Mach-Zehnder-Interferometer treten. Bei einer solchen Ausführungsform wird das Licht des Lasers in an sich bekannter Art auf die zwei Arme des Mach-Zehnder-Interferometers aufgeteilt. Ein Arm wird dabei durch eine Sensorfaser und der andere Arm durch eine Referenzfaser gebildet. Die Teilsignale der beiden Arme werden zur Interferenz gebracht und in eine elektrisches Differenzsignal umgewandelt, das dann in der bereits beschriebenen Weise verarbeitet und zur Arbeitspunktkontrolle resp. Modulation verwendet werden kann.

Grundsätzlich können Modulation und Arbeitspunktkontrolle wahlweise im Sensor- oder Referenzarm vorgenommen werden. Es entspricht jedoch einer bevorzugten Ausführungsform der Erfindung, die Modulation im Sensorarm vorzunehmen. Dadurch können Fluktuationen des Signals geringer gehalten werden. Der Sensorarm sieht dann ähnlich wie in Fig. 1 resp. Fig. 6 aus, allerdings mit dem Unterschied, dass die Sensorfaser nicht als TMF sondern eine gewöhnliche Monomodefaser betrieben wird. Für die Mach-Zehnder-Anordnung sind dann noch zusätzlich zwei Faserkoppler erforderlich, die einen Teil des Laserlichts in resp. aus der Referenzfaser koppeln.

Das Mach-Zehnder-Interferometer hat gegenüber dem TMFI den Vorteil grösserer Empfindlichkeit. In bezug auf die Arbeitspunktkontrolle mittels Wellenlängenänderung ist zu beachten, dass die Arme des Mach-Zehnder-Interferometers unterschiedlich lang sein müssen. Es gilt folgende Beziehung für die Phasenverschiebung:

$$\delta\phi = 2\pi\, \delta l\, \delta\lambda/\lambda^2$$

$\delta l$ = optischer Weglängenunterschied zwischen den Armen Für eine korrekte Detektion muss $\delta l$ kleiner als die Kohärenzlänge des Laserlichts sein.

Für $\delta l$ = 0.01 m, $\lambda$= 830 nm und $\delta\lambda$= 0.1 nm ergibt sich $\delta\phi$ = 9.1 rad. Dies reicht aus, um die erfindungsgemässe separate Arbeitspunktkontrolle durchführen zu können.

Zu den Sensorelementen ist folgendes zu sagen. Grundsätzlich sind für die Erfindung alle Arten piezoelektrischer Sensoren verwendbar. Besonders bevorzugt sind aber die richtungsemfindlichen, wie sie z.B. aus der Veröffentlichung EP-A-0 316 619 als solche bekannt sind. Während nämlich bei einem Modulator gemäss Fig. 2 ein elektrisches Feld mit wohldefinierter Richtung auf den Kristall des Modulators einwirkt, ist im allgemeinen die Richtung des zu messenden Feldes unbekannt. Wenn also die Sensorelemente (und damit gemäss der Erfindung auch die Modulatorelemente) nicht richtungsempfindlich sind, dann kann es vorkommen, dass die Feldstärke des zu messenden Feldes nicht in wohldefinierter Beziehung zur Spannung (resp. zum Steuersignal) steht, die an die Elektroden des Modulators angelegt wird.

Aus der Gruppe der richtungsempfindlichen Sensorelemente sind all jene besonders bevorzugt, die sich auf einfache Weise zu einem zylindrischen oder prismatischen Körper stapeln lassen. Dazu gehören neben den scheibenförmigen beispielsweise auch die plättchenförmigen, rechteckigen Sensorelemente, bei denen die Sensorfaser auf einer Hauptfläche fixiert ist (und zwar parallel zu einer Kante des Plättchens) und die kristallographisch so orientiert sind, dass ausschliesslich eine Feldkomponente senkrecht zur Plättchennormalen zu einer Längenänderung der Sensorfaser führen kann. Solche plättchenförmige Sensorelemente können analog zu Fig. 2 aufgestapelt werden. Die Sensorfaser verläuft dann aber nicht am Rand sondern zwischen den einzelnen Plättchen hindurch.

Für die Kristallklasse Td (Schoenflies-Notation), zu welcher u.a. die III-V-Halbleiter (z.B. GaAs) gehören, bedeutet das, dass eine $4^{quer}$-zählige Drehachse senkrecht zum Plättchen steht und die Sensorfaser einen 45°-Winkel mit einer anderen $4^{quer}$-zähligen Drehachse bildet.

Eine weitere stapelbare Variante bilden solche plättchenförmige Sensorelemente, bei denen die Sensorfaser ebenfalls auf einer Hauptfläche parallel zu einer Kante fixiert ist, die aber eine kristallographische Orientierung von der Art aufweist, dass ausschliesslich eine Richtungskomponente parallel zu der genannten Hauptfläche zu einer Längenänderung der Sensorfaser führen kann. Die soeben genannten Sensorelemente werden z.B. mit den Hauptflächen aneinandergefügt. Die Elektroden des Modulators sind dann an den in einer Ebene liegenden, schmalen Seiten der Kristallplättchen angebracht. Die Elektroden werden, mit anderen Worten, auf zwei einander gegenüberliegenden, längsseitigen Flächen des prismatischen Stapels angeordnet.

Für die Kristallklasse D3 (Schoenflies-Notation), zu welcher z.B. $\alpha$-Quarz gehört, bedeutet das, dass die empfindliche Richtungskomponente parallel zur 2-zähligen Drehachse und die Sensorfaser nicht parallel zur 3-zähligen Drehachse orientiert ist.

Eine weitere Variante besteht darin, die plättchenförmigen Sensorelemente des vorhergehenden Beispiels mit den Schmalseiten, die in Richtung der empfindlichen Achse des jeweiligen Sensorelements liegen, aneinander zu fügen. Die Elektroden des Modulators sind dann an den aneinanderliegenden Schmalseiten, also zwischen den Sensorelementen (vergleichbar zu Fig. 2) angeordnet.

Anhand der beschriebenen, besonders bevorzugten stapelbaren Ausführungsformen lassen sich ohne Mühe weitere Beispiele konstruieren, die ebenfalls im Rahmen der Erfindung liegen.

Abschliessend kann festgestellt werden, dass mit der Erfindung eine Messvorrichtung geschaffen worden ist, die sich durch hohe Messgenauigkeit infolge Arbeitspunktkontrolle, galvanische Trennung zwischen Sensor und Detektor und geringen Platzbedarf auszeichnet.

**BEZEICHNUNGSLISTE**

1a, 1b - Laser; 2 - Sensorfaser; 3 - Sensorelement; 4 - Arbeitspunktregler; 5, 26 - Modulator; 6 - Detektionsmittel; 7a, 7b, 9a, 9b - PI-Regler; 8, 10 - Verstärker; 11 - Reset-Schaltung; 12a,...,12e - Modulatorelement; 13a,...,13f - Elektrode; 14a,...,14c - Träger; 15a,...,15c - Halterung; 16a, 16b - Blattfedern; 17 - Elektromagnet; 18 - Achse; 19 - Bimetallstreifen; 20 - Heizelement; 21 - Stromquelle; 22a, 22b - Halterung; 23 - Schrittmotor; 24 - Schneckengetriebe; 25 - Spannungssensor; 27a, 27b - Auswerteschaltung.

## Patentansprüche

1. Faseroptischer Sensor zum Messen elektrischer Felder oder Spannungen, bei welchem
   a) eine Sensorfaser (2) mit einem gegebenen Längenabschnitt so an mindestens einem piezoelektrischen Sensorelement (3) befestigt ist, dass das zu messende elektrische Feld mittels des inversen piezoelektrischen Effekts zu einer Längenänderung der Sensorfaser (2) führt,
   b) Mittel zur interferometrischen Detektion (6) der Längenänderung vorgesehen sind und
   c) ein piezoelektrischer Modulator (5,26) vorgesehen ist, welcher derart angesteuert ist, dass die durch das zu messende elektrische Feld induzierte Längenänderung der Sensorfaser (2) kompensiert wird,
   dadurch gekennzeichnet, dass
   d) der piezoelektrische Modulator (5,26) mindestens ein piezoelektrisches Modulatorelement (12a) umfasst, welches bezüglich Material, geometrischer Form und Kristallorientierung identisch mit dem mindestens einen Sensorelement (3) ist,
   e) Modulatorelement (12a) und Sensorelement (3) sich im wesentlichen auf gleicher Temperatur befinden und
   f) zusätzlich separate Mittel zur Arbeitspunktkontrolle (4) vorgesehen sind.

2. Faseroptischer Sensor nach Anspruch 1, dadurch gekennzeichnet, dass die Mittel zur interferometrischen Detektion (6) auf der Interferenz zweier Moden in einer Sensorfaser beruhen oder in der Art eines Mach-Zehnder-Interferometers ausgebildet sind.

3. Faseroptischer Sensor nach Anspruch 1, dadurch gekennzeichnet, dass das mindestens eine Sensorelement (3) und das entsprechende, mindestens eine Modulatorelement (12a) richtungsempfindlich sind.

4. Faseroptischer Sensor nach Anspruch 1, dadurch gekennzeichnet, dass
   a) mehrere Modulatorelemente (12a, 12b, 12c, 12d, 12e) vorgesehen sind,
   b) die Modulatorelemente zu einem einfachen prismatischen oder zylindrischen Körper stapelbar sind und
   c) zu einem Stapel zusammengefügt sind, in welchem alle Modulatorelemente parallel geschaltet sind.

5. Faseroptischer Sensor nach Anspruch 1, dadurch gekennzeichnet, dass
   a) die Modulatorelemente (12a,12b, 12c, 12d, 12e) scheibenförmig und aus einkristallinem Quarz sind und ausschliesslich eine Komponente des elektrischen Feldes detektieren, die parallel zu einer Scheibennormalen sind, und dass sie
   b) so zu einem Stapel zusammengefügt sind, dass benachbarte Modulatorelemente eine entgegengesetzt gleiche Orientierung haben und
   c) zwischen den aneinander liegenden Modulatorelementen Elektroden zum parallelen Ansteuern der Modulatorelemente vorgesehen sind.

6. Faseroptischer Sensor nach Anspruch 1, dadurch gekennzeichnet, dass die Mittel zur Arbeitspunktkontrolle (4) einen Faserstrecker, insbesondere einen piezokeramischen Hohlzylinder, umfassen.

7. Faseroptischer Sensor nach Anspruch 1, dadurch gekennzeichnet, dass das mindestens eine Sensorelement (3) und der Modulator (5,26) auf die gleiche Sensorfaser einwirken.

8. Faseroptischer Sensor nach Anspruch 1, dadurch gekennzeichnet, dass die Mittel zur interferometrischen

Detektion (6) einen Laser (1a, 1b) mit veränderbarer Wellenlänge und die Mittel zur Arbeitspunktkontrolle (4) eine Schaltung zum Steuern der Wellenlänge des Lasers umfassen.

**9.** Faseroptischer Sensor nach Anspruch 1, dadurch gekennzeichnet, dass
a) zum Ansteuern des piezoelektrischen Modulators (5, 26) ein erster PI-Regler (7a,7b) mit einer oberen Grenzfrequenz oberhalb einer Frequenz des zu messenden elektrischen Feldes vorgesehen ist,
b) die Mittel zur Arbeitspunktkontrolle (4) einen zweiten PI-Regler (9a,9b) mit einer oberen Grenzfrequenz unterhalb der genannten Frequenz sowie
c) eine Reset-Schaltung (11) zum Rücksetzen des zweiten PI-Reglers entsprechend einer Phasenverschiebung von einem Vielfachen von $2\pi$ umfassen.

**10.** Verfahren zum Messen eines elektrischen Feldes oder einer elektrischen Spannung, bei welchem
a) Licht, das in einer Sensorfaser (2) geführt wird, durch eine mittels eines piezoelektrischen Sensorelements (3) induzierte Längenänderung der Sensorfaser (2) eine Phasenverschiebung erleidet,
b) die Phasenverschiebung interferometrisch detektiert wird und
c) mit einem auf die Sensorfaser (2) einwirkenden piezoelektrischen Modulator (5,26) gemäss einem Steuersignal auf Null abgeglichen wird, wobei aus dem Steuersignal die Stärke des Feldes resp. der Spannung ermittelt wird,
dadurch gekennzeichnet, dass
d) im Modulatur (5,26) Modulatorelemente (12a, 12b, 12c, 12d, 12e) verwendet werden, die bezüglich Material geometrischer Form und Kristallorientierung identisch mit dem piezoelektrischen Sensorelement (3) sind,
e) Sensor- und Modulatorelemente auf gleicher Temperatur gehalten werden und
f) zur Arbeitspunktkontrolle ein separater Arbeitspunktregler (4) mit grossem Phasenhub verwendet wird, so dass ein Dynamikbereich von mindestens $+/-2\pi$ erreicht wird,

## Claims

**1.** Fibre-optic sensor for measuring electric fields or voltages, in which
a) a sensor fibre (2) with a given length segment is fixed to at least one piezoelectric sensor element (3) in such a way that the electric field to be measured leads by means of the inverse piezoelectric effect to a change in length of the sensor fibre (2),
b) means are provided for the interferometric detection (6) of the change in length, and
c) a piezoelectric modulator (5, 26) is provided which is driven in such a way that the change in length of the sensor fibre (2) induced by the electric field to be measured is compensated,
characterized in that
d) the piezoelectric modulator (5, 26) comprises at least one piezoelectric modulator element (12a) which in terms of material, geometric shape and crystal orientation is identical to the at least one sensor element (3),
e) the modulator element (12a) and sensor element (3) are essentially at the same temperature, and
f) separate means for operating point control (4) are additionally provided.

**2.** Fibre-optic sensor according to Claim 1, characterized in that the means for interferometric detection (6) are based on the interference of two modes in a sensor fibre, or are constructed in the manner of a Mach-Zehnder interferometer.

**3.** Fibre-optic sensor according to Claim 1, characterized in that the at least one sensor element (3) and the corresponding, at least one modulator element (12a) are directionally sensitive.

**4.** Fibre-optic sensor according to Claim 1, characterized in that
a) a plurality of modulator elements (12a, 12b, 12c, 12d, 12e) are provided,
b) the modulator elements can be stacked to form a simple prismatic or cylindrical body, and,
c) are assembled to form a stack in which all the modulator elements are connected in parallel.

**5.** Fibre-optic sensor according to Claim 1, characterized in that
a) the modulator elements (12a, 12b, 12c, 12d, 12e) are disc-shaped and made from monocrystalline quartz and exclusively detect a component of the electric field and which are parallel to a disc normal, and in that they

b) are assembled to form a stack in such a way that neighbouring modulator elements have an orientation which is the same in the opposite sense, and in that
c) electrodes for driving the modulator elements in parallel are provided between the juxtaposed modulator elements.

6. Fibre-optic sensor according to Claim 1, characterized in that the means for operating point control (4) comprise a fibre stretcher, in particular a piezoceramic hollow cylinder.

7. Fibre-optic sensor according to Claim 1, characterized in that the at least one sensor element (3) and the modulator (5, 26) act on the same sensor fibre.

8. Fibre-optic sensor according to Claim 1, characterized in that the means for interferometric detection (6) comprise a laser (la, lb) of variable wavelength, and the means for operating point control (4) comprise a circuit for controlling the wavelength of the laser.

9. Fibre-optic sensor according to Claim 1, characterized in that
a) a first PI controller (7a, 7b) with an upper cut-off frequency above a frequency of the electric field to be measured is provided for the purpose of driving the piezoelectric modulator (5, 26), and
b) the means for operating point control (4) comprise a second PI controller (9a, 9b) with an upper cut-off frequency below the said frequency as well as
c) a reset circuit (11) for resetting the second PI controller in accordance with a phase shift of a multiple of $2\pi$.

10. Method for measuring an electric field or an electric voltage, in which
a) light which is guided in a sensor fibre (2) undergoes a phase shift due to a change in length of the sensor fibre (2) induced by means of a piezoelectric sensor element (3),
b) the phase shift is detected interferometrically, and
c) null-balancing is carried out in accordance with a control signal by means of a piezoelectric modulator (5, 26) acting on the sensor fibre (2), the strength of the field or the voltage being determined from the control signal,
characterized in that
d) use is made in the modulator (5, 26) of modulator elements (12a, 12b, 12c, 12d, 12e) which in terms of material, geometric shape and crystal orientation are identical to the piezoelectric sensor element (3),
e) the sensor elements and modulator elements are kept at the same temperature, and
f) use is made for the operating point control of a separate operating point controller (4) with large phase-angle deviation, with the result that a dynamic range of at least $+/-2\pi$ is achieved.

## Revendications

1. Capteur à fibre optique pour la mesure de champs ou de tensions électriques, dans lequel :
a) une fibre de détection (2) est fixée par un segment de longueur donnée à au moins un élément capteur piézo-électrique (3), de telle manière que le champ électrique à mesurer provoque, par l'effet piézo-électrique inverse, une variation de longueur de la fibre de détection (2);
b) un moyen de détection interférométrique (6) de la variation de longueur est prévu, et
c) un modulateur piézo-électrique (5, 26) est prévu, ce modulateur étant commandé de manière à compenser la variation de longueur de la fibre de détection (2) induite par le champ électrique à mesurer;
caractérisé en ce que :
d) le modulateur piézo-électrique (5, 26) comporte au moins un élément modulateur piézo-électrique (12a) qui est identique quant à sa matière, sa forme géométrique et son orientation cristalline, audit au moins un élément capteur (3);
e) les éléments modulateur (12a) et capteur (3) sont maintenus essentiellement à la même température, et
f) des moyens séparés supplémentaires sont prévus pour le contrôle du point de travail (4) séparé.

2. Capteur à fibre optique selon la revendication 1, caractérisé en ce que les moyens de détection interférométrique (6) reposent sur l'interférence de deux modes dans une fibre de détection ou sont constitués

d'un interféromètre Mach-Zehnder.

3. Capteur à fibre optique selon la revendication 1, caractérisé en ce qu'au moins un élément capteur (3) et ledit au moins un élément modulateur (12a) correspondant sont directionnels.

4. Capteur à fibre optique selon la revendication 1, caractérisé en ce que
   a) plusieurs éléments modulateurs (12a, 12b, 12c, 12d, 12e) sont prévus;
   b) les éléments modulateurs peuvent être empilés pour former un simple corps prismatique ou cylindrique, et
   c) peuvent être assemblés en un empilage dans lequel tous les éléments modulateurs sont connectés en parallèle.

5. Capteur à fibre optique selon la revendication 1, caractérisé en ce que :
   a) les éléments modulateurs (12a, 12b, 12c, 12d, 12e) sont de forme discoïde, sont constitués d'un monocristal de quartz et ne détectent que les composantes du champ électrique parallèles à une normale au disque, et ils
   b) sont empilés de manière que les éléments modulateurs voisins présentent une orientation de même direction et de sens opposé, et
   c) entre les éléments modulateurs adjacents sont placées des électrodes assurant l'excitation en parallèle des éléments modulateurs.

6. Capteur à fibre optique selon la revendication 1, caractérisé en ce que les moyens de contrôle du point de travail (4) comportent un extenseur de fibre, en particulier un cylindre creux piézo-céramique.

7. Capteur à fibre optique selon la revendication 1, caractérisé en ce que ledit au moins un élément capteur (3) et le modulateur (5, 26) agissent sur la même fibre de détection.

8. Capteur à fibre optique selon la revendication 1, caractérisé een ce que les moyens pour la détection interférométrique (6) comportent un laser (1a, 1b) à longueur d'onde variable et les moyens pour le contrôle du point de travail (4) comportent un circuit de commande de la longueur d'onde du laser.

9. Capteur à fibre optique selon la revendication 1, caractérisé en ce que :
   a) pour l'excitation du modulateur piézo-électrique (5, 26) est prévu un premier régulateur PI (7a, 7b) d'une fréquence limite supérieure plus élevée qu'une fréquence du champ électrique à mesurer;
   b) les moyens de contrôle du point de travail (4) comportent un deuxième régulateur PI (9a, 9b) d'une fréquence limite supérieure moins élevée que la fréquence susmentionnée, et
   c) un circuit de remise à l'état initial (11) pour ramener à l'état initial le deuxième régulateur PI en concordance avec un déphasage d'un multiple de $2\pi$.

10. Procédé de mesure d'un champ ou d'une tension électrique, dans lequel :
   a) la lumière conduite dans une fibre de détection (2) subit un déphasage par suite d'une variation de longueur de la fibre de détection (2) induite par un élément capteur piézo-électrique (3);
   b) le déphasage est détecté par interférométrie, et, est
   c) ramené à zéro par un modulateur piézo-électrique (5, 26) agissant sur la fibre de détection (2), en fonction d'un signal de commande à partir duquel est calculée l'intensité du champ ou la tension;
   caractérisé en ce que :
   d) dans le modulateur (5, 26) sont utilisés des éléments modulateurs (12a, 12b, 12c, 12d, 12e) qui sont identiques quant à leur matière, leur forme géométrique et leur orientation cristalline, à l'élément capteur piézo-électrique (3);
   e) les éléments capteur et modulateur sont maintenus à la même température, et
   f) pour le contrôle du point de travail (4) est utilisé un régulateur de point de travail séparé à grande amplitude de déphasage, ce qui permet d'obtenir une plage dynamique d'au moins +/- 2 $\pi$.

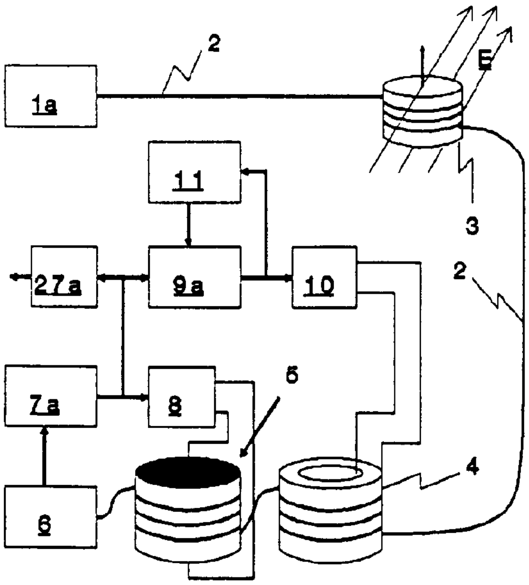


Fig. 1

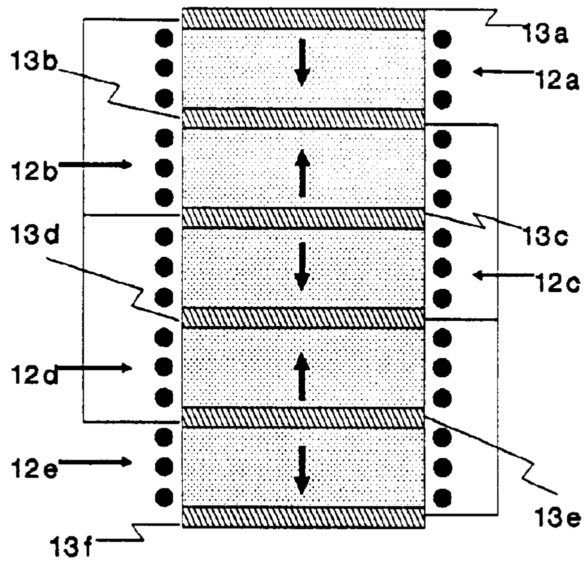


Fig. 2

Fig. 3

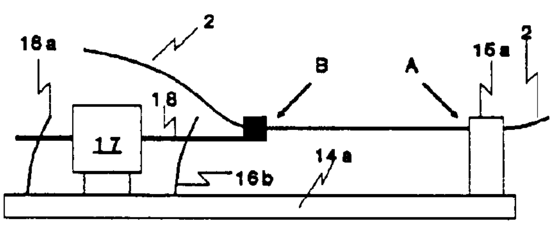


Fig. 4

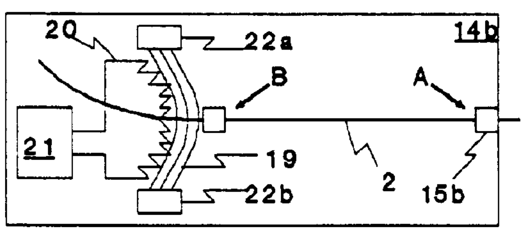


Fig. 5

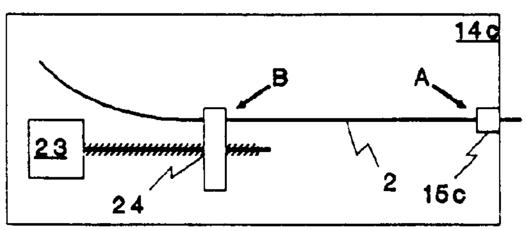

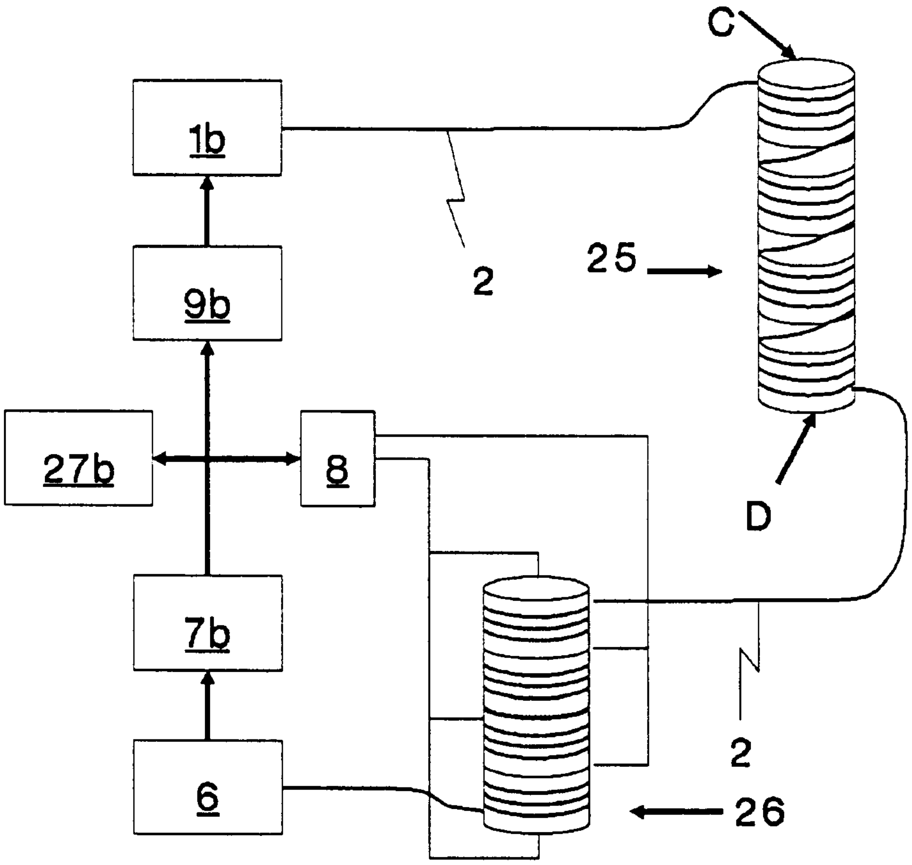


Fig. 6